Europäisches Patentamt

European Patent Office

Office européen des brevets

(11) Veröffentlichungsnummer : **0 124 029
B1**

# (12) EUROPÄISCHE PATENTSCHRIFT

(45) Veröffentlichungstag der Patentschrift :
29.07.87

(51) Int. Cl.⁴ : **H 05 K 7/20**, H 01 L 23/34, H 01 L 23/36

(21) Anmeldenummer : **84104423.3**

(22) Anmeldetag : **18.04.84**

(54) **Ein elektrisches Bauteil tragendes, gut kühlbares Schaltungsmodul.**

(30) Priorität : **29.04.83 DE 3315583**

(43) Veröffentlichungstag der Anmeldung :
**07.11.84 Patentblatt 84/45**

(45) Bekanntmachung des Hinweises auf die Patenterteilung : **29.07.87 Patentblatt 87/31**

(84) Benannte Vertragsstaaten :
**DE FR GB NL SE**

(56) Entgegenhaltungen :
**WO-A-81 /037 34
WO-A-83 /000 74
US-A- 3 753 056**

(73) Patentinhaber : **Siemens Aktiengesellschaft Berlin
und München
Wittelsbacherplatz 2
D-8000 München 2 (DE)**

(72) Erfinder : **Prussas, Herbert, Dipl.-Ing.
Heinrich-Schütz-Weg 31
D-8000 München 60 (DE)**

EP 0 124 029 B1

## Beschreibung

Die Erfindung betrifft ein spezielles Schaltungsmodul der Nachrichtentechnik, welches insbesondere für SLIC-Bauteile eines digitalen Fernsprech-Vermittlungssystems entwickel wurde —
welches nämlich 2 Watt und mehr elektrische
Verlustleistung auf kleinstem Raume erzeugt. Die
Erfindung ist jedoch darüber hinaus auch auf den
sonstigen Gebieten der Nachrichtentechnik dort
verwendbar, wo relativ hohe Verlustleistungen
kleiner Bauteile rasch als Verlustwärme abgeleitet
werden sollen.

Die Erfindung geht von dem im Oberbegriff des
Patentanspruchs 1 angegebenen Schaltungsmodul aus, das für sich durch die US 3,753,056, Fig.
3 bis 5 vorbekannt ist. Bei diesem bekannten
Schaltungsmodul besteht der auf dem Kühlblech
stumpf befestigte Kühlblock aus Kupfer.

Beim Stand der Technik wird also mittels des
im Fenster des Trägers angebrachten Kühlblocks
bereits erreicht, daß

die Wärmeableitung vom Bauteil zum Kühlblech
auch bei kurzzeitigen thermischen Spitzenbelastungen des Bauteils relativ gut ist,

die erzeugte Verlustwärme bei Spitzenbelastung auch ohne Selbstzerstörung relativ gut im
Kühlblock zwischengespeichert werden kann,

bei der Herstellung des Schaltungsmoduls der
im Fenster angebrachte, am Kühlblech befestigte
Kühlkörper gleichzeitig zur groben Justierung
des Kühlbleches beim Befestigen des Kühlbleches am Träger ohne wesentliche Einbuße der
Wärmeleiteigenschaften dienen kann, was die
Befestigung bzw. Justierung des Kühlbleches am
Träger während der Herstellung des Schaltungsmoduls insbesondere bei vollautomatischem Herstellungsverfahren erleichtert, und

das Bauteil am Kühlblech mit hohem Abstand
des Bauteils vom Kühlblech befestigt ist, und
zwar in einem solchen Abstand, daß die elektrischen Verbindungen zwischen den elektrischen
Anschlüssen des Bauteils und den auf der ersten
Oberfläche des Trägers angebrachten Leitungen
unschwer, insbesondere in einem vollautomatischem Produktionsgang z. B. durch Bonden, herstellbar sind.

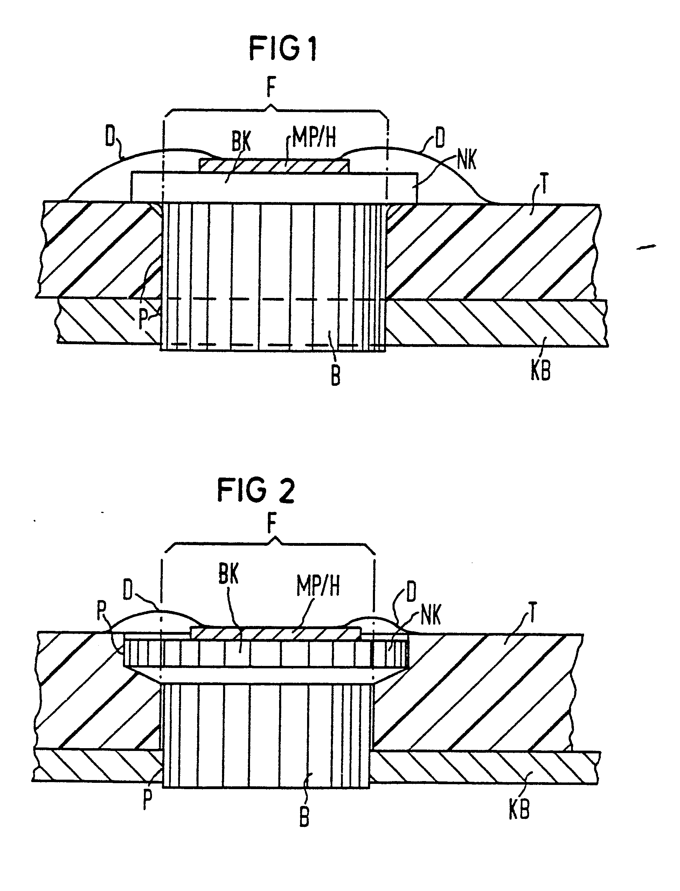

Durch die DE-OS 23 30 732, Fig. 5 und in der
zugehörenden Beschreibung ab S. 9, Abs. 2 ist
ein Schaltungsmodul mit einem Fenster in einem
Träger bekannt. Das Fenster liegt zwischen einem
geripptem Kühlblech und einem Halbleiterbauteil
und ist durch Lötzinn ausgefüllt. Dieses Lötzinn
hat angenähert ähnliche Eigenschaften wie der
Kühlblock in der US 3,753,056.

Durch die DE-OS 20 61 603, insbesondere Fig. 4
bis 7 und S. 11, Abs. 1 ist ein weiteres Schaltungsmodul mit langem metallischen Kühlkörper bekannt, an dessen einer Stirnfläche ein Halbleiterkörper sowie ein Flansch befestigt ist. Der
Halbleiterkörper liegt im Inneren eines Fensters
eines isolierenden Trägers, wobei der Kühlkörper
säulenartig senkrecht hoch aufragend auf dem
Träger so befestigt ist, daß der Flansch die Oberfläche des Trägers als Anschlag eben noch berührt.

Die Aufgabe der Erfindung ist, den bei der
Erfindung im Fenster des Trägers angebrachten
Kühlkörper so abzuändern bzw. so zu verbessern
daß jener im Fenster angebrachte Kühlkörper bei
hohen thermischen Spitzenbelastungen die Verlustwärme noch besser ableiten, noch besser
zwischenspeichern, und auch noch besser abstrahlen kann, als dies bereits bei dem durch die
US 3,753,056 bekannten Schaltungsmodul der
Fall ist, so daß wegen dieser Verbesserung der
thermischen Eigenschaften noch höhere thermische Belastungen, vor allem eine noch höhere
thermische Spitzenbelastung des Bauteils, zugelassen werden können.

Diese Aufgabe der Erfindung wird durch die im
Patentanspruch 1 angegebenen Maßnahmen gelöst.

Die in den Unteransprüchen angegebenen
Maßnahmen gestatten zusätzliche Vorteile, nämlich noch zusätzliche Funktionen des im Fenster
und in der Öffnung angebrachten massiven metallischen Kühlblockes :

Es gestatten nämlich die Maßnahmen gemäß
Patentanspruch

2. den Nietkopf im Träger so zu versenken, daß
die erste Oberfläche und die die Bauteileanschlüsse enthaltende Bauteileoberfläche angenähert eine gemeinsame Ebene bilden, wodurch
insbesondere die elektrischen Verbindungen zwischen den Leitungen der ersten Oberfläche und
den Bauteileanschlüsse, z. B. beim Bonden, erleichtert werden,

3. eine Zerstörung der Rändelungsteile, die
zum Festklemmen am Kühlblech dienen, beim
Eindrücken des Kühlkörpers durch den Träger
hindurch in das Kühlblech, zu vermeiden,

4. durch geschickte Wahl der Wärmeausdehnungskoeffizienten des Kühlblocks zu erreichen, daß besonders selten, bzw. erst bei sehr
hohen Verlustleistungen, ein Abplatzen des auf
dem Kühlblock angebrachten elektrischen Bauteils auch bei starker Erwärmung auftritt, und

5. den Kühlblock zusätzlich zur Zuleitung von
einer elektrischen Vorspannung an das Bauteil
mit auszunutzen.

Die Erfindung wird anhand von zwei in den
Figuren gezeigten Ausführungsbeispielen weiter
erläutert, wobei die Figur

1 einen Seitenansicht-Schnitt durch ein erstes
Ausführungsbeispiel mit nietartigem Kühlblock
und

2 den Seitenansicht-Schnitt durch ein zweites
Ausführungsbeispiel mit nietartigem Kühlblock
und versenktem Nietkopf
zeigen.

Bei den in den beiden Figuren gezeigten Ausführungsbeispielen enthält das Schaltungsmodul
jeweils den Träger T, welcher zumindest an seiner
ersten Oberfläche isolierende Eigenschaften aufweist, nämlich an jener Oberfläche, welche Leitungen trägt und dem Kühlblech KB abgewandt ist. Diese Leitungen sind über angebondete Drähte D mit den entsprechenden Anschlüssen des Bauteils MP/H verbunden. Der Träger T kann also z. B. aus Keramik oder Kunststoff bestehen, wobei die Leitungen z. B. auch durch Siebdrucken, oder sogar in Dickschichttechnik durch Ätzen aus aufgeklebtem Kupferblech oder dgl. gebildet sein können.

Zur guten Kühlung des Bauteils MP/H ist im Träger T ein hier rundes Fenster in Form einer durchgehenden Bohrung durch den Träger T angebracht, wobei im Fenster F ein massiver metallischer Kühlblock B mit Nietkopf NK zwischen dem Bauteil MP/H und dem Kühlblech KB angebracht ist. Das metallische Kühlblech KB bedeckt mindestens einen Teil jener den Leitungen gegenüberliegenden, zweiten Oberfläche des Trägers T rund um das Fenster F, wobei der Kühlblock B, mittels Rändelung und Stecken durch Fenster und Öffnung, so zwischen das Bauteil MP/H und dem Kühlblech KB eingefügt werden kann, daß dieser Kühlblock B einen niedrigen Wärmeübergangswiderstand sowohl am Nietkopf NK, nämlich zwischen dem Bauteil MP/H und dem Kühlblock B, als auch am Fuße dieses Kühlblockes, nämlich zwischen dem Kühlblock B und dem Kühlblech KB aufweist. Besonders niedrig ist dieser Wärmeübergangswiderstand, wenn das Bauteil MP/H mittels einer ganz dünnen Leitkleberschicht auf dem Kühlblock B aufgeklebt ist. Andererseits kann der Kühlblock B auf dem Kühlblech KB, evtl. auch durch zusätzliches Punkten, weitgehend spaltfrei und entsprechend endgültig befestigt sein.

Der massive Kühlblock B leitet dann wegen seiner hohen Wärmeleitfähigkeit, wegen seiner niedrigen Wärmeübergangswiderstände und wegen seiner eigenen Wärmespeicherkapazität, besonders wegen seiner hohen Wärmespeicherkapazität im Bereich seines Nietkopfes NK, schnell und stark die Verlustwärme vom Bauteil MP/H ab und leitet diese Verlustwärme an das Kühlblech KB rasch weiter. Weil die bei der Erfindung große Oberfläche des Nietkopfes NK im allgemeinen nur wenig vom Bauteil MP/H bedeckt ist, also großflächig frei liegt, kann diese freie Oberfläche selber besonders gut auch Wärme abstrahlen und auch durch Konvektion unmittelbar Wärme an die Luft über der freien Oberfläche des Nietkopfes NK abgeben — überdies kann der Nietkopf NK wegen seiner eigenen erhöhten Wärmekapazität Verlustwärme, insbesondere bei sehr hohen Spitzenlasten, besonders gut zwischenspeichern und schließlich die Wärme auch bis zum Kühlblech KB weiterleiten. Hohe kurzzeitige Spitzenleistungen von z. B. 5 Watt und mehr können daher bei der Erfindung rasch vom Bauteil MP/H abgeleitet bzw. auch kurzzeitig zwischengespeichert werden.

Bei der Herstellung kann der am Kühlblech KB befestigte nietartige Kühlblock B mit seinem Fuß voraus in das Fenster F gesteckt und mittels der Rändelung — wenn nicht sogar endgültig, dann zumindest vorläufig, bevorzugt am Kühlblock und am Träger — befestigt werden, wodurch der Kühlblock B gleichzeitig auch zur — zumindest vorläufigen — Justierung des Kühlbleches KB am Träger T ohne wesentliche Einbuße seiner Wärmeleiteigenschaften dienen kann. Die Befestigung des Kühlbleches KB am Träger T mittels des Kühlblockes B erleichtert insbesondere die Anwendung von vollautomatischen Herstellungsverfahren für solche Schaltungsmodule.

Der Kühlblock B ist ähnlich dem Druckknopf der Textiltechnik selbstklemmend im Fenster F festklemmbar. Er dient zusätzlich zur Befestigung des Kühlbleches KB am Träger T. Zur Verstärkung dieser Befestigung kann das Kühlblech KB an der zweiten Oberfläche des Trägers T, und/oder der Kühlblock B im Fenster F, zusätzlich mittels eines, z. B. besonders elastischen, Klebstoffes am Träger T befestigt sein. Je elastischer der Klebstoff ist, um so weniger müssen Wärmeausdehnungskoeffizient-Unterschiede zwischen dem Träger T und dem Kühlblech KB bzw. Kühlblock B selbst bei sehr hohen Verlustwärmemengen beachtet werden.

Der massive Kühlblock B hat ferner wegen seines als Anschlag nutzbaren Nietkopfes NK eine schon beim Konstruieren gut definierbare Höhe bzw. Länge, wobei ebenfalls der Abstand zwischen dem Bauteil MP/H und dem Kühlblech KB, in für eine Massenfertigung günstiger Weise gut definierbar ist. Dadurch ist bei Bedarf auch die vollautomatische Anbringung von elektrischen Verbindungen, z. B. Drähten D, zwischen den oft zahlreichen Anschlüssen des Bauteils MP/H und den Leitungen auf dem Träger unschwer möglich.

Bei den in den Figuren 1 und 2 gezeigten Ausführungsbeispielen ist der Kühlblock B jeweils rund und jeweils sowohl an dem Träger T zugewandten als auch an dem Kühlblech KB zugewandten Oberflächen gerändelt. Bei dem in Fig. 1 gezeigten Beispiel ist der ganze Schaft des Kühlblockes B gerändelt und damit — zumindest vorläufig — der Träger T selbstklemmend im Fenster, sowie das Kühlblech KB selbstklemmend in der Öffnung am Kühlblech B befestigt ; der Nietkopf NK wirkt hier zudem als Anschlag an der ersten Oberfläche. Bei diesem Beispiel klemmt also über diese Rändelung der Kühlblock B selbstklemmend sowohl im ganzen Fenster als auch in der Öffnung aufgrund der hier entsprechend klein gewählten Durchmesser sowohl des Fensters im Träger T als auch der Öffnung im Kühlblech KB- und zwar sobald der Kühlblock B durch das Fenster F und zusätzlich durch die entsprechende Öffnung im Kühlblech KB bei der Montage des Schaltungsmoduls gesteckt wurde, wobei der das Bauteil MP/H tragende Nietkopf NK beim Einpressen des gerändelten Kühlblockes B in das Fenster und in die Öffnung als Anschlag dient.

Das in Figur 2 gezeigte Ausführungsbeispiel hat einen Nietkopf NK, der in den Träger T versenkt ist, wodurch das Bauteil MP/H bzw. dessen elektrische Anschlüsse etwa in der gleichen Ebene wie die elektrischen Anschlüsse der Leitungen auf dem Träger T liegen. Wegen dieser etwa gleichen Ebene, also wegen dieser Versenkung des Nietkopfes NK, können die elektrischen Verbindungen zwischen den Leitungen auf der ersten Oberfläche des Trägers T und den Anschlüssen auf dem Bauteil MP/H in für viele Fälle sehr angenehmer Weise besonders leicht hergestellt werden, z. B. durch das hier bei Massenfertigung besonders leicht mögliche Anbonden der Drähte D. Auch gewisse Siebdruckverfahren, z. B. zur Herstellung von Widerstandsschichten MP/H auf dem Nietkopf NK, können bei diesem Ausführungsbeispiel auch noch nach dem Befestigen des Kühlblocks B im Träger T angewendet werden.

Darüber hinaus hat der versenkte Nietkopf NK des Kühlblockes B bei dem in Figur 2 gezeigten Ausführungsbeispiel auch eine Rändelung rund um seinen Außenumfang dort, wo er einen selbstklemmenden Preßsitz P in der entsprechenden Vertiefung des Trägers T aufweist. Im übrigen ist der Durchmesser des Fensters im Träger T unterhalb des Nietkopfes NK so groß, daß dort die Rändelung des Kühlblockes B nicht mehr den Träger T berührt; im Fenster ist hier zwischen dem Träger T und dem Schaft des Kühlblockes B ein Spalt. Der unterste Bereich des Schaftes des Kühlblockes B weist aber eine Rändelung auf, durch die ein Preßsitz P in der Öffnung des Kühlbleches KB hergestellt ist. Bei diesem Ausführungsbeispiel ist also der Träger T über die Rändelung P des versenkten Nietkopfes NK am Kühlblock B und damit — jedenfalls vorläufig — auch am Kühlblech KB befestigt; daher weist der Kühlblock B hier zwei Preßsitze P auf nämlich einerseits unten am Schaft in der Öffnung des Kühlbleches KB, und andererseits oben in der Versenkung im Träger T im Bereich des Nietkopfes NK des Kühlblockes B.

Bei diesem Ausführungsbeispiel wird zwar der Schaft des Kühlblockes B bei der Montage des Schaltungsmoduls ebenfalls durch den Träger T hindurch in die Öffnung des Kühlbleches KB hineingedrückt, also insoweit in gleicher Weise wie bei dem in Fig. 1 gezeigten Ausführungsbeispiel. Bei dem in Fig. 1 gezeigten Ausführungsbeispiel ist aber der Preßsitz P der Rändelung im hier engen Fenster des Trägers T fast spaltlos selbstklemmend demnach die Rändelung des Schaftes im Bereich der im Kühlblech angebrachten Öffnung oft bereits mehr oder weniger flach gedrückt. Bevorzugt wird daher beim Beispiel gem. Fig. 1 häufig, den Durchmesser der Öffnung dementsprechend noch etwas kleiner als den Durchmesser des Fensters zu wählen und/oder den Durchmesser des Schaftes im Bereich der Öffnung etwas kleiner als im Bereich des Fensters zu wählen.

Bei dem in Fig. 2 gezeigten Ausführungsbeispiel ist jedoch die Rändelung des Schaftes des Kühlblockes B im Bereich der Öffnung des Kühlbleches KB stets frisch, also noch nicht flach gedrückt, wenn der Schaft des Kühlblockes B zuerst durch das hier weite, sogar den Spalt aufweisende Fenster des Trägers T, und erst danach durch die hier enge Öffnung des Kühlbleches KB hindurchgedrückt wird. Bei dem in Figur 2 gezeigten Ausführungsbeispiel ist also die Befestigung des Kühlbleches KB am Kühlblock B und damit am Träger T, wegen dieser Frische der Rändelung in der Öffnung des Kühlbleches KB, im allgemeinen besser als bei dem in Fig. 1 gezeigten Ausführungsbeispiel.

An der vom Kühlblech KB bedeckten zweiten Oberfläche des Trägers T können übrigens bei beiden Beispielen zusätzliche Leitungen isoliert vom Kühlblech KB angebracht werden, welche eigene Spannungen zum Bauteil MP/H, insbesondere über Durchkontaktierungen, weiterleiten können. Es ist also im Prinzip möglich, nicht nur auf der ersten Oberfläche des Trägers T Leitungen anzubringen.

Die Erfindung läßt im Prinzip, je nach der Wahl der Materialien und je nach den Anforderungen an die Maßgenauigkeiten, zu, daß der Kühlkörper B zusätzlich durch weitere Mittel, z. B. durch Löten Stauchen Punkten und/oder Kleben, am Träger T und/oder am Kühlblech KB befestigt wird.

Der Wärmeausdehnungskoeffizient des Metalls des Kühlblockes B kann, bevorzugt für Betriebsfälle mit sehr hohen thermischen Spitzenbelastungen, möglichst ähnliche Werte wie der Wärmeausdehnungskoeffizient des Bauteils MP/H aufweisen, zumindest jeweils im Bereich des Überganges zwischen einerseits dem Nietkopf NK des Kühlblockes B und andererseits dem Bauteil MP/H — abseits dieser Berührungsflächen können also sowohl das Bauteil MP/H als auch der Kühlblock B wegen der Wahl anderer Materialien noch andere Ausdehnungskoeffizienten aufweisen. Durch eine solche geschickte Wahl der Wärmeausdehnungskoeffizienten zumindest im Bereich des Überganges zwischen dem Nietkopfes NK und dem Bauteil MP/H platzt das Bauteil MP/H selbst bei hohen Temperaturen bzw. bei hohen Spitzenverlustleistungen kaum noch ab.

Das Bauteil MP/H kann an sich bei der Erfindung völlig verschiedener Art sein. So kann das Bauteil MP/H z. B. ein Laser und/oder Widerstandsschicht sein, welche bekanntlich oft besonders hohe (Spitzen-) Verlustwärmemengen entwickeln, also thermische Belastungen, welche besonders rasch abgeführt werden müssen, um die Zerstörung des Bauteils MP/H zu vermeiden. Das Bauteil MP/H kann auch ein Halbleiterchip H sein, dessen Betriebsverhalten gestört würde, wenn er wegen seiner Verlustwärmeentwicklung zu heiß würde. Dieser Halbleiterchip H kann auch ein sogenanntes Mikropack MP bilden, was dann die Herstellung des Schaltungsmoduls in vollautomatischen Herstellungsverfahren mit besonders hohen Stückzahlen pro Stunde gestattet, vgl. z. B. Siemens bauteile report 16 (1978), Heft 2, Seiten 40 bis 44, electronic industrie 9-1976 (13. Okt. 1976), Seite 227 und VDI-nachrichten (29. Aug. 1980) Seite 5 « Chips rollen von der Filmspule ».

Wenn also das Bauteil ein im Betrieb die Verlustwärme leitendes Halbleitersubstrat H enthält, insbesondere weil dieses Bauteil ein Chip bzw. Mikropack ist, dann beträgt der Wärmeausdehnungskoeffizient dieses Halbleitersubstrates, wenn es z. B. aus Silizium besteht, $2,5 \cdot 10^{-6}$. Günstig wäre also, die Kühlblockoberfläche, dort wo sie das Bauteil bzw. das Halbleitersubstrat berührt, möglichst gleich groß, also $2,5 \cdot 10^{-6}$ zu wählen. Es zeigte sich, daß es für viele Anwendungsfälle aber bereits ausreichend ist, wenn dann der Wärmeausdehnungskoeffizient des Kühlblockes B an der betreffenden Oberfläche des Nietkopfes NK grob angenähert gleich groß wie der Wärmeausdehnungskoeffizient des Silizium-Halbleitersubstrates H ist : So könnte der Kühlblock B, zumindest die betreffende Nietkopfoberfläche, z. B. aus Molybdän mit dem Wärmeausdehnungskoeffizienten $5,3 \cdot 10^{-6}$, oder aus Wolfram mit dem Wärmeausdehnungskoeffizienten $4,5 \cdot 10^{-6}$ oder z. B. auch aus der Alloy-Legierung mit dem Wärmeausdehnungskoeffizienten $4,7 \cdot 10^{-6}$ hergestellt sein. Das Abplatzen ist dann auch bei hohen Temperaturen nur noch selten zu beobachten ; jedenfalls ist die Abplatzgefahr sehr viel geringer, als wenn man den ganzen Kühlblock B z. B. aus Kupfer mit dem Wärmeausdehnungskoeffizienten $17 \cdot 10^{-6}$, oder aus Aluminium mit dem Wärmeausdehnungskoeffizienten $24 \cdot 10^{-6}$ hergestellt hätte.

Der in den Figuren gezeigte Kühlblock B hat darüber hinaus den Vorteil, daß er zusätlich zur Zuleitung einer elektrischen Vorspannung an das Bauteil MP/H bzw. an dessen Substrat H mit ausgenutzt werden kann. Dazu sollen die Übergänge zwischen einerseits dem Kühlblech KB und dem Kühlblock B und andererseits zwischen dem Nietkopf NK des Kühlblockes B und dem Halbleitersubstrat H einen möglichst geringen elektrischen Übergangswiderstand aufweisen. Ein so niedriger Übergangswiderstand ist insbesondere zwar bereits durch die Rändelung am Schaft im Bereich der Öffnung erreichbar ; sie ist aber weiter verbesserbar, wenn der Kühlblock B auf dem Kühlblech KB, nach dem Befestigen mittels der Rändelung, noch zusätzlich aufgepunktet ist. Ein niedriger elektrischer Übergangswiderstand zwischen dem Nietkopf NK des Kühlblocks B und dem (Substrat des) Bauteil MP/H ist durch entsprechende Befestigung dieses Bauteils MP/H, auch z. B. mittels einer hauchdünnen Leitkleberschicht, auf dem Nietkopf NK erreichbar.

Das Bauteil MP/H kann zum Schutz gegen nachträgliche Beschädigung auch durch eine Schutzschicht, z. B. einen Kunststofftropfen, abgedeckt werden.

**Patentansprüche**

1. Ein elektrisches Bauteil (MP/H) tragendes gut kühlbares Schaltungsmodul mit einem Träger (T), z. B. aus Keramik oder Kunststoff, zum Tragen von auf seiner ersten Oberfläche angebrachten Leitungen,

einem Fenster (F) bzw. einer durchgehenden Bohrung im Träger (T),

einem metallischen Kühlblech (KB), das mindestens einen Teil einer den Leitungen gegenüberliegenden, zweiten Oberfläche des Trägers (T) rund um das Fenster (F) bedeckt, und

einem im Fenster (F) angebrachten massiven metallischen, bevorzugt runden Kühlblock (B), der einerseits zwischen dem im und/oder auf dem Fenster (F) angebrachten, mit den Leitungen z. B. über Drähte (D) leitend verbundenen, im Betrieb Verlustwärme abgebenden elektrischen Bauteil und andererseits dem Kühlblech (KB) mit niedrigem Wärmeübergangswiderstand zwischen dem Bauteil (MP/H) und dem Kühlblech (KB) liegt, dadurch gekennzeichnet, daß

im Kühlblech (KB) unter dem Fenster (F) eine mit dem Fenster (F) fluchtende Öffnung angebracht ist, und der Kühlblock (B)

an seinem dem Kühlblech (UB) abgewendeten, der ersten Oberfläche nahen Ende einen Nietkopf (NK), auf dem das elektrische Bauteil (MP/H) — z. B. Halbleiterchip (H) und/oder Laser und/oder Widerstandsschicht und/oder Mikropack (MP) — angebracht ist, aufweist,

zumindest an klemmenden Abschnitten seiner Seitenflächen gerändelt ist, und

selbstklemmend im Fenster (F) und/oder in der Öffnung des Kühlbleches (KB) festgeklemmt ist.

2. Schaltungsmodul nach Patentanspruch 1, dadurch gekennzeichnet, daß

der Seitenrand (P) des Nietkopfes (NK) sowie der Seitenrand im Bereich der Öffnung des Kühlbleches (UB) gerändelt ist,

das Fenster (F) nahe der ersten Oberfläche, nämlich im Bereich des Nietkopfes (NK), örtlich so erweitert ist, daß in dieser Erweiterung der Seitenrand (P) des im Träger (T) versenkten Nietkopfes festklemmt.

3. Schaltungsmodul nach Patentanspruch 2, dadurch gekennzeichnet, daß das Fenster (F) überall um so viel größer als die Öffnung des Kühlbleches (KB) ist, daß der unter dem Nietkopf (NK) liegende Schaft des Kühlblockes (B) nicht mehr am Träger (T) festklemmt.

4. Schaltungsmodul nach Patentanspruch 1, 2 oder 3, dadurch gekennzeichnet, daß der Wärmeausdehnungskoeffizient des Metalls des Kühlblocks (B), mindestens der Oberfläche seines Nietkopfes (NK) in der Nähe des Bauteils (H), welches ein auf dem Nietkopf (NK) befestigtes Halbleitersubstrat (H) enthält, ähnlich groß wie der Wärmeausdehnungskoeffizient des Halbleitersubstrates (H) ist.

5. Schaltungsmodul nach einem der vorhergehenden Patentansprüche, dadurch gekennzeichnet, daß

zur Zuführung einer konstanten Vorspannung (Erde) an das ein Halbleitersubstrat (H) eines Halbleiterchip (H) enthaltende Bauteil (H),

die Übergänge zwischen einerseits dem Kühlblech (KB) und dem Kühlblock (B), und andererseits dem Nietkopf (NK) des Kühlblockes (B) und dem auf dem Nietkopf (NK) befestigten Halbleitersubstrat (H), einen niedrigen elektrischen Widerstand aufweisen.

## Claims

1. A circuit module which can be well cooled and which carries an electrical component (MP/H), comprising

a carrier (T), consisting, for example, of ceramic or synthetic resin, which carries conductors applied to a first surface thereof, .

a window (F) or a through bore in the carrier (T),

a metal cooling plate (KB) which covers at least a part of a second surface of the carrier (T), lying opposite to the conductors, around the window (F), and

a solid metal, preferably round, cooling block (B) which is arranged in the window (F) and which, is located between, on the one hand, the electrical component which is arranged in and/or on the window (F), is conductively connected to the conductors, for example, by wires (D), and which emits heat due to losses during operation, and, on the other hand, the cooling plate (KB), with a low heat transmission resistance between the component (MP/H) and the cooling plate (KB), characterised in that

an opening is provided, in alignment with the window (F), in the cooling plate (KB) under the window (F) and

the cooling block (B)

is provided at its end which faces away from the cooling plate (UB) and is near to the first surface, with a rivet head (NK) on which the electrical component (MP/H) — e. g. a semiconductor chip (H) and/or a laser and/or a resistance layer and/or a micropack (MP) — is arranged,

is milled at least at clamping sections of its side surfaces, and

is clamped in the window (F) and/or in the opening of the cooling plate (KB) in self-locking fashion.

2. A circuit module as claimed in Claim 1, characterised in that

the side edge (P) of the rivet head (NK) and the side edge in the region of the opening of the cooling plate (UB) is milled,

close to the first surface, namely in the region of the rivet head (NK), the window (F) is locally widened in such manner that the side edge (P) of the rivet head inlet in the carrier (T) is clamped in this widened portion.

3. A circuit module as claimed in Claim 2, characterised in that the overall size of the window (F) exceeds the size of the opening in the cooling plate (KB) to such an extent that the shaft of the cooling block (B), which is located beneath the rivet head (NK), is no longer clamped against the carrier (T).

4. A circuit module as claimed in Claim 1, 2 or 3, characterised in that the coefficient of thermal expansion of the metal of the cooling block (B) — at least at the surface of its rivet head (NK) in the vicinity of the module (H) which contains a semiconductor substrate (H) attached to the rivet head (NK) — has a similar value to that of the coefficient of thermal expansion of the semiconductor substrate (H).

5. A circuit module as claimed in one of the preceding Claims, characterised in that

in order that a constant bias voltage (earth) may be supplied to the component (H) which contains a semiconductor substrate (H) of a semiconductor chip (H),

the junctions between, on the one hand, the cooling plate (KB) and the cooling block (B), and, between, on the other hand, the rivet head (NK) of the cooling block (B) and the semiconductor substrate (H) attached to the rivet head (NK), have a low electrical resistance.

## Revendications

1. Module de circuit portant un composant électrique (MP/H) et susceptible d'être correctement refroidi, comportant

un support (T), par exemple en céramique ou en une matière plastique, servant à porter des conducteurs montés sur sa première surface,

une fenêtre (F) ou un perçage traversant, ménagé dans le support (T),

une tôle métallique de refroidissement (KB) qui recouvre, tout autour de la fente (F), une partie d'une seconde surface du support (T), qui se situe en face des conducteurs, et

un bloc de refroidissement (B) massif, de préférence rond, disposé dans la fenêtre (F) et qui se situe, d'une part, entre le composant électrique dégageant de la chaleur dissipée en fonctionnement, monté dans et/ou sur la fenêtre (F) et relié aux conducteurs (par exemple B) à l'aide de fils (D), et, d'autre part, la tôle de refroidissement (KB) avec une faible résistance à la transmission de chaleur entre le composant (MP/H) et la tôle de refroidissement (KB), caractérisé par le fait que

dans la tôle de refroidissement (KB), sous la fenêtre (F), est ménagée une ouverture alignée avec la fenêtre (F), et

le bloc de refroidissement (B)

comporte, près de son extrémité éloignée de la tôle de refroidissement (KB) et voisine de la première surface, une tête de rivet (NK) sur laquelle est monté le composant électrique (MP/H) — par exemple une puce (H) et/ou un laser, et/ou une couche résistive et/ou un micro-boîtier (MP) —,

est moleté au moins en des sections à coincement de ses surfaces latérales, et

est bloqué par auto-coincement dans la fenêtre (F) et/ou dans l'ouverture de la tôle de refroidissement (KB).

2. Module de circuit selon la revendication 1, caractérisé par le fait que

le bord latéral (P) de la tête de rivet (NK) ainsi que le bord latéral dans le voisinage de l'ouverture de la tôle de refroidissement (KB) sont moletés,

la fenêtre (F), près de la première surface, plus précisément dans le voisinage de la tête de rivet (NK) est élargie localement de telle façon que dans cet élargissement est coincé le bord latéral (P) de la tête de rivet qui est noyée dans le support (T).

3. Module de circuit selon la revendication 2, caractérisé par le fait que la fenêtre (F) est, partout, plus grande que l'ouverture de la tôle de refroidissement (KB) d'une quantité telle que la tige du bloc de refroidissement (B), qui se situe en dessous de la tête de rivet (NK), n'est plus coincée dans le support (T).

4. Module de circuit selon la revendication 1, 2 ou 3, caractérisé par le fait que le coefficient de dilatation thermique du métal du bloc de refroidissement (B), au moins de la surface de sa tête de rivet (NK) dans le voisinage du composant (H) qui comporte un substrat semi-conducteur (H) qui est fixé sur la tête de rivet (NK), a une valeur qui est similaire à celle du coefficient de dilatation thermique du substrat semi-conducteur (H).

5. Module de circuit selon l'une des revendications précédentes, caractérisé par le fait que

pour amener une polarisation constante (terre) au composant (H) qui comporte un substrat semi-conducteur (H) d'une puce semi-conductrice (H),

les transitions entre, d'une part, la tôle de refroidissement (KB) et le bloc de refroidissement (B), et, d'autre part, la tête de rivet (NK) du bloc de refroidissement (B) et le substrat semi-conducteur (H) fixé sur la tête de rivet (NK), présentent une faible résistance électrique.

# FIG 1

# FIG 2

1